# EUROPÄISCHE PATENTANMELDUNG

(11) **EP 1 065 746 A2**
(43) Veröffentlichungstag der Anmeldung: **03.01.2001**
(21) Anmeldenummer: 00111287.9
(22) Anmeldetag: 25.05.2000
(51) Int. Cl.: H01Q 1/24

(54) **Leiterplatte mit HF-Modul und Verfahren zur Kontaktierung von integrierten Antennen auf einer Leiterplatte**

(30) Priorität: 16.06.1999 DE 19927581
(71) Anmelder: SIEMENS AKTIENGESELLSCHAFT, 80333 München (DE)
(72) Erfinder: Lungwitz, Matthias, 46399 Bocholt (DE)

(57) **Zusammenfassung**

Die Erfindung betrifft eine Leiterplatte (1) für eine Sende/Empfangsvorrichtung mit einem HF-Modul mit einem HF-Eingang (2), einem HF-Ausgang (3) und mit elektrischen Bauelementen, die auf der Leiterplatte (1) angeordnet sind, wobei mindestens eine Leiterbahn (4) zwischen HF-Modul und Antenne (5) vorgesehen ist.

Die Erfindung zeichnet sich dadurch aus, daß die Leiterplatte (1) eine Bohrung (6) aufweist, welche die mindestens eine Leiterbahn (4) zwischen der Antenne (5) und dem HF-Modul derart durchtrennt, daß durch ein nachträglich in die Bohrung (6) eingebrachtes Befestigungselement (7) eine leitende Verbindung zwischen dem HF-Modul und der Antenne (5) entsteht, wodurch eine Reduktion des manuellen Aufwands in der Fertigung erreicht wird.

## Beschreibung

Die Erfindung betrifft eine Leiterplatte für eine Sende/Empfangsvorrichtung mit einem HF-Modul mit einem HF-Eingang, einem HF-Ausgang und mit elektrischen Bauelementen, die auf der Leiterplatte angeordnet sind, wobei mindestens eine Leiterbahn zwischen HF-Modul und Antenne vorgesehen ist.

Bei einem HF-Modul wird am jeweiligen HF-Eingang oder HF-Ausgang eine Antenne benötigt. Dazu wird das Sende-, sowie das Empfangs-Signal dem HF-Modul zugeführt.

Zur Prüfung der Funktionsfähigkeit des HF-Moduls, muß der HF-Eingang und HF-Ausgang mit einem HF-Prüfpunkt auf der Leiterplatte versehen werden. Durch diesen ist es möglich, relevante HF-Parameter, wie zum Beispiel Sendeleistung und Empfängerempfindlichkeit durch geeignete Meßgeräte zu testen. Zum Zeitpunkt der Prüfung ist es allerdings erforderlich, daß sich an dem Prüfpunkt keine weiteren Verbraucher, wie im besonderen Fall Antennen, befinden. Gelöst wurde dieses Problem bisher durch Montage beziehungsweise Anschluß der Antennne im Anschluß an den Prüfvorgang.

Im Zuge der weiteren Integration von schnurlosen mobilen Anwendungen können die Antennen auf der Leiterplatte integriert werden. Die Antennen erstrecken sich über die Leiterplatte und sind immer am notwendigen Prüfpunkt angeschlossen. Hierdurch ergibt sich das oben aufgeführte Problem bei der Prüfung der HF-Parameter. Nach dem Stand der Technik wird die Antennenzuführung nach der Prüfung manuell durch eine Handlötstelle auf der Leiterplatte hergestellt. Dies führt zu einem großen Aufwand in der Fertigung und zu verlängerten Fertigungszeiten für jede einzelne Leiterplatte.

Es ist daher Aufgabe der Erfindung, eine Leiterplatte für eine Sende/Empfangsvorrichtung mit einem HF-Modul mit einem HF-Eingang, einem HF-Ausgang und mit elektrischen Bauelementen, die auf der Leiterplatte angeordnet sind, wobei mindestens eine Leiterbahn zwischen HF-Modul und Antenne vorgesehen ist, dahingehend zu verbessern, daß eine Reduzierung des manuellen Aufwands in der Fertigung erreicht wird.

Es ist weiterhin Aufgabe der Erfindung, ein Verfahren zur Kontaktierung von Antennen auf der Leiterplatte gemäß dem Oberbegriff des Anspruches 11 zu entwickeln, das eine Reduzierung des Arbeitsaufwandes bewirkt.

Die Aufgabe zur Vorrichtung wird durch die Merkmale des Anspruches 1 gelöst. Die Aufgabe zum Verfahren wird durch die Merkmale des Anspruches 11 gelöst.

Zur Durchführung des erfindungsgemäßen Verfahrens schlägt der Erfinder vor, ein Verfahren zur Kontaktierung von Antennen auf der Leiterplatte, sowie eine Leiterplatte für eine Sende/Empfangsvorrichtung mit einem HF-Modul mit einem HF-Eingang, einem HF-Ausgang und mit elektrischen Bauelementen, die auf der Leiterplatte angeordnet sind, wobei mindestens eine Leiterbahn zwischen HF-Modul und Antenne vorgesehen ist, dahingehend zu verbessern, daß eine Bohrung die Leiterbahn zwischen Antenne und HF-Modul durchtrennt. Ein nachträglich in die Bohrung eingebrachtes Befestigungselement stellt eine leitende Verbindung zwischen dem HF-Modul und der Antenne dar.

Hierbei kann die Antenne in der Leiterplatte integriert vorliegen. Die Bohrung bewirkt, daß zum Zeitpunkt der Prüfung kein Kontakt zwischen Antenne und HF-Prüfpunkt besteht.

Befinden sich um die Bohrung zwei metallische Flächen, die sich jedoch gegenseitig nicht berühren, so kann die elektrische Verbindung zwischen der Antenne und dem HF-Eingang oder dem HF-Ausgang mit einem Befestigungselement, das aus einem leitenden Material besteht, hergestellt werden, wenn das Befestigungselement durch die Bohrung geführt wird. Als elektrisch leitendes Befestigungselement kann man sich zum Beispiel eine Niete oder eine Schraube vorstellen. Für eine Verwendung herkömmlicher Schrauben oder Nieten bietet sich eine Normierung des Durchmessers der Bohrung an.

Ist eine Befestigung des HF-Moduls an einem Trägermaterial, wie zum Beispiel an einem Gehäuse vorgesehen, so kann der manuelle Fertigungsaufwand durch die Verwendung einer Schraube reduziert werden, vorzugsweise mit einer geeigneten Scheibe, zum Beispiel einer Zahnscheibe. Hierbei wird die gleichzeitige Kontaktierung von Antenne und HF-Modul sowie die Befestigung an dem Trägermaterial ermöglicht.

Als vorteilhaft sind auch die durch eine kürzere Fertigungszeit verbundenen geringeren Kosten anzusehen.

Es versteht sich, daß die vorstehend genannten und nachstehend noch zu erläuternden Merkmale der Erfindung nicht nur in der jeweils angegebenen Kombination, sondern auch in anderen Kombinationen oder in Alleinstellung verwendbar sind, ohne den Rahmen der Erfindung zu verlassen.

Weitere Merkmale der Erfindung ergeben sich aus den Unteransprüchen und der nachfolgenden Beschreibung eines Ausführungsbeispiels unter Bezugnahme auf die Zeichnung.

Im folgenden wird die Erfindung anhand der einzigen Zeichnung beschrieben:

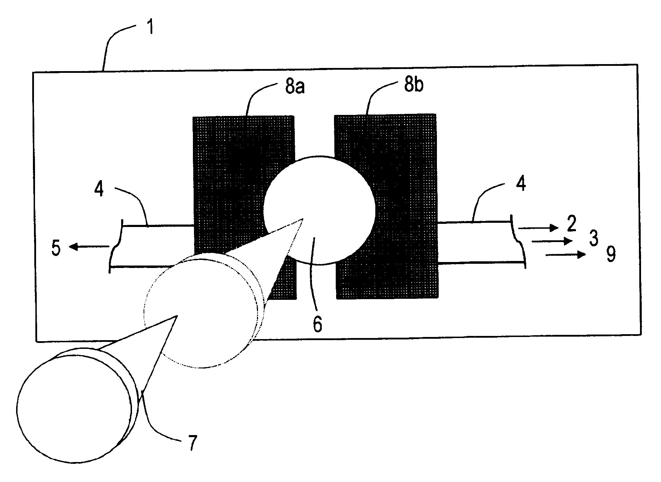

Figur 1 zeigt ein Schema eines Ausschnittes der erfindungsgemäßen Leiterplatte 1 für eine Sende/Empfangsvorrichtung.

Hierbei durchtrennt die Bohrung 6 die Leiterbahn 4. Die Leiterbahn 4 führt auf der einen Seite zu der Antenne 5, auf der anderen Seite zu dem HF-Eingang 2 beziehungsweise dem HF-Ausgang 3 und zu dem HF-Prüfpunkt 9. Rund um die Bohrung sind zwei metallische Flächen 8a und 8b so angeordnet, daß sie sich gegenseitig nicht berühren. Hierbei steht die eine metallische Fläche 8a in elektrischem Kontakt mit der Antenne 5, die andere metallische Fläche 8b in elektrischem Kontakt mit dem HF-Eingang 2 beziehungsweise dem HF-Ausgang 3 und mit dem HF-Prüfpunkt 9.

Die Prüfung der HF-Parameter kann nun ohne die Verbindung zu einem Verbraucher, wie zum Beispiel der Antenne 5, stattfinden. Nach der Prüfung der Parameter wird die elektrische Verbindung zwischen Antenne 5 und HF-Eingang 2 oder HF-Ausgang 3 mit einem Befestigungselement 7 hergestellt, das aus einem leitenden Material besteht. Hierbei kann es sich sowohl um eine Schraube, vorzugsweise mit einer geeigneten Scheibe, zum Beispiel einer Zahnscheibe, als auch um eine Niete handeln. Soll die Befestigung der Leiterplatte 1 in einem Gehäuse stattfinden, wird gleichzeitig zur Kontaktierung eine Befestigung durch eine Schraube ermöglicht.

## Patentansprüche

1. Leiterplatte (1) für eine Sende/Empfangsvorrichtung mit einem HF-Modul mit einem HF-Eingang (2), einem HF-Ausgang (3) und mit elektrischen Bauelementen, die auf der Leiterplatte (1) angeordnet sind, wobei mindestens eine Leiterbahn (4) zwischen HF-Modul und Antenne (5) vorgesehen ist, **dadurch gekennzeichnet,** daß die Leiterplatte (1) eine Bohrung (6) aufweist, welche die mindestens eine Leiterbahn (4) zwischen der Antenne (5) und dem HF-Modul derart durchtrennt, daß durch ein nachträglich in die Bohrung (6) eingebrachtes Befestigungselement (7) eine leitende Verbindung zwischen dem HF-Modul und der Antenne (5) herstellbar ist.

2. Leiterplatte für eine Sende/Empfangsvorrichtung gemäß dem voranstehenden Anspruch 1, **dadurch gekennzeichnet*****,*** daß sich um die Bohrung (6) zwei metallische Flächen (8a, 8b) befinden.

3. Leiterplatte für eine Sende/Empfangsvorrichtung gemäß dem voranstehenden Anspruch 2, **dadurch gekennzeichnet**, daß sich die zwei metallischen Flächen (8a, 8b) gegenseitig nicht berühren.

4. Leiterplatte für eine Sende/Empfangsvorrichtung gemäß einem der voranstehenden Ansprüche 2 bis 3, **dadurch gekennzeichnet**, daß die eine metallische Fläche (8a) elektrisch mit der Antenne (5), die andere metallische Fläche (8b) mit dem HF-Eingang (2) oder HF-Ausgang (3) des HF-Moduls verbunden ist.

5. Leiterplatte für eine Sende/Empfangsvorrichtung gemäß einem der voranstehenden Ansprüche 1 bis 4, **dadurch gekennzeichnet**, daß das Befestigungselement (7) eine Kontaktierung der Leiterbahn (4) bewirkt.

6. Leiterplatte für eine Sende/Empfangsvorrichtung gemäß dem voranstehenden Anspruch 5, **dadurch gekennzeichnet**, daß das Befestigungselement (7) aus einem leitenden Material besteht.

7. Leiterplatte für eine Sende/Empfangsvorrichtung gemäß einem der voranstehenden Ansprüche 5 bis 6, **dadurch gekennzeichnet**, daß das Befestigungselement (7) eine Niete darstellt.

8. Leiterplatte für eine Sende/Empfangsvorrichtung gemäß einem der voranstehenden Ansprüche 5 bis 7, **dadurch gekennzeichnet**, daß das Befestigungselement (7) eine Schraube darstellt.

9. Leiterplatte für eine Sende/Empfangsvorrichtung gemäß einem der voranstehenden Ansprüche 1 bis 8, **dadurch gekennzeichnet**, daß die Antennen (5) in der Leiterplatte (1) integriert vorliegen.

10. Leiterplatte für eine Sende/Empfangsvorrichtung gemäß einem der voranstehenden Ansprüche 1 bis 9, **dadurch gekennzeichnet**, daß eine Befestigung an ein Trägermaterial (Gehäuse) vorgesehen ist.

11. Verfahren zur Kontaktierung von Antennen (5) auf einer Leiterplatte (1) für eine Sende/Empfangsvorrichtung mit einem HF-Modul mit einem HF-Eingang (2), einem HF-Ausgang (3) und mit elektrischen Bauelementen, die auf der Leiterplatte (1) angeordnet sind, wobei mindestens eine Leiterbahn (4) zwischen dem HF-Modul und der Antenne (5) vorgesehen ist, **dadurch gekennzeichnet**, daß eine Bohrung (6), welche die Leiterbahn (4) zwischen der Antenne (5) und dem HF-Modul durchtrennt, durch ein nachträgliches Einbringen eines Befestigungselementes (7) in die Bohrung (6) eine leitende Verbindung zwischen dem HF-Modul und der Antenne (5) hergestellt wird.

12. Verfahren gemäß dem voranstehenden Anspruch 11, **dadurch gekennzeichnet**, daß eine Prüfung des HF-Moduls ohne Antennenkontakt stattfindet.

13. Verfahren gemäß einem der voranstehenden Ansprüche 11 bis 12, **dadurch gekennzeichnet**, daß die elektrische Kontaktierung zwischen Antenne (5) und HF-Modul über zwei benachbart angeordnete metallische Flächen hergestellt wird, wobei die eine metallische Fläche (8a) elektrisch mit der Antenne (5), die andere metallische Fläche (8b) mit dem HF-Eingang (2) oder HF-Ausgang (3) des HF-Moduls verbunden ist.

14. Verfahren gemäß dem voranstehenden Anspruch 13, **dadurch gekennzeichnet**, daß die Kontaktierung durch Befestigung der Leiterplatte (1) in einem Gehäuse stattfindet.

15. Verfahren gemäß einem der voranstehenden Ansprüche 11 bis 14, **dadurch gekennzeichnet**, daß die Antennen (5) in der Leiterplatte (1) integriert werden.
